# EUROPÄISCHE PATENTSCHRIFT

(11) **EP 0 398 156 B1**
(45) Veröffentlichungstag und Bekanntmachung des Hinweises auf die Patenterteilung: **20.07.1994**
(21) Anmeldenummer: 90108812.0
(22) Anmeldetag: 10.05.1990
(51) Int. Cl.: F25D 3/10, F17C 13/00, F04D 19/02, F25B 9/00, H01F 7/22

(54) **Verfahren und Vorrichtung zum Vorkühlen des Heliumtanks eines Kryostaten**
Method and device for precooling the helium vessel of a cryostat
Procédé et dispositif pour préréfrigérer le réservoir d'hélium d'un cryostat

(30) Priorität: 18.05.1989 DE 3916212
(43) Veröffentlichungstag der Anmeldung: 22.11.1990
(73) Patentinhaber: SPECTROSPIN AG, CH-8117 Fällanden (CH)
(72) Erfinder: Mraz, Beat, CH-8634 Hombrechtikon (CH); Nötzli, Christoph, CH-8603 Schwerzenbach (CH); Ungricht, Ernst, Dr., CH-8610 Uster (CH); Marek, Daniel, Dr., CH-8604 Volketswil (CH)
(74) Vertreter: KOHLER SCHMID + PARTNER

(56) Entgegenhaltungen:
- WO-A-88/05519
- DE-C- 3 724 562
- FR-A- 2 038 536
- GB-A- 952 451
- US-A- 2 956 732
- US-A- 3 850 004
- IEEE Transactions on Magnetics, Vol. 24, No. 2, March 1988, pages 1230 to 1232

## Beschreibung

Die Erfindung betrifft eine Vorrichtung und ein Verfahren zum Vorkühlen des Heliumtanks eines Kryostaten auf etwa die Temperatur von siedendem Stickstoff, insbesondere eines optischen Kryostaten mit optischen Komponenten im Heliumtank, oder eines NMR-Kryostaten bzw. eines medizinischen NMR-Kryostaten für Kernspintomographie für die Aufnahme einer supraleitenden Magnetspule, mit einem abgeschlossenen, Heliumgas beinhaltenden Kreislauf, über den wenigstens der zu kühlende Heliumtank des Kryostaten und ein Wärmetauscherraum eines von siedendem Stickstoff umgebenen Wärmetauschers miteinander verbunden sind.

Eine derartige Vorrichtung ist im wesentlichen aus der Druckschrift "IEEE Transactions on Magnetics, Vol. 24, No. 2, March 1988, S. 1230 bis 1232" mit Ausnahme der optionalen Merkmale eines "optischen Kryostaten mit optischen Komponenten im Heliumtank, oder eines NMR-Kryostaten bzw. eines medizinischen NMR-Kryostaten für Kernspintomographie" bekannt.

Aufgrund der Temperaturunterschiede im Heliumgas wird zwar bei einer derartigen Vorrichtung ein natürlicher Umlauf des Heliumgases im geschlossenen Kreislauf bewirkt, wenn man das System sich selbst überläßt, doch ist der Volumendurchsatz und die Strömungsgeschwindigkeit des Heliumgases beim natürlichen Umlauf beliebig gering, so daß die Vorkühlung des Heliumtanks eine sehr lange Zeit in Anspruch nehmen würde. Anders ausgedrückt wäre bei einer derartigen Vorrichtung der Austrag an Wärmemenge pro Zeiteinheit aus dem Kryostaten mit Hilfe des kalten Heliumgases beliebig gering.

Die US-A-3 850 004 beschreibt eine Vorrichtung für die Aufnahme einer supraleitenden Magnetspule, mit einem abgeschlossenen, Heliumgas beinhaltenden Kreislauf, über den wenigstens der zu kühlende Heliumtank eines Kryostaten und ein Wärmetauscherraum eines Wärmetauschers miteinander verbunden sind, wobei der Kreislauf einen Verdichter zum Fördern des Heliumgases aufweist.

Weitere Kryostaten zur Aufnahme einer supraleitenden Magnetspule sind beispielweise aus dem Bereich der Kernresonanzspektrometrie oder Kernspintomographie bekannt (DE-A-29 06 060, DE-C-37 24 562). Dieser Kryostat weist mehrere ineinandergeschachtelte Behälter auf, von denen der innerste eine Magnetspule enthält und im Betrieb mit flüssigem Helium mit einer Temperatur von etwa 4 K gefüllt ist. Ein äußerer Tank enthält flüssigen Stickstoff mit einer Temperatur von etwa 77 K. Beide Tanks sind gegeneinander und gegen Raumtemperatur vakuumisoliert, wobei die evakuierten Zwischenräume Strahlungsschilder auf Zwischentemperaturen enthalten, so daß sowohl der Wärmeübergang als auch die Wärmestrahlung auf ein Minimum reduziert ist. Vor der ersten Inbetriebnahme bzw. nach einer Wartung oder Reparatur an der Magnetspule oder dem Kryostaten muß dieser auf die Betriebstemperaturen abgekühlt werden. Aus dem Stand der Technik sind mehrere Verfahren bekannt, wie der Kryostat auf diese Betriebstemperaturen abgekühlt werden kann. Bei einem Verfahren wird vorgeschlagen, den Stickstofftank mit flüssigem Stickstoff und den Heliumtank mit flüssigem Helium aufzufüllen und auf diese Art abzukühlen. Dazu würden jedoch große Mengen an flüssigem Helium benötigt, da die Magnetspule und der Innenraum des Kryostaten allein durch das verflüssigte Helium abgekühlt werden müßten. Das flüssige Helium hat trotz der geringen Temperatur von 4 K eine wesentlich kleinere Kapazität Wärme aufzunehmen als flüssiger Stickstoff bei einer Temperatur von 77 K. Hieraus folgt neben dem großen Verbrauch an flüssigem Helium, das außerdem noch teuer ist, aufgrund des geringeren Wärmeaufnahmevermögens, ein erheblicher Aufwand an Zeit. Diese Nachteile können auch dadurch nicht gerechtfertigt werden, daß der Heliumtank zur Vermeidung von Verunreinigungen ausschließlich mit dem Kühlmedium Helium in Berührung kommt, insbesondere wenn der Tank Elemente mit großer Wärmekapazität enthält, wie z.B. eine supraleitende Magnetspule.

Bei einem anderen Verfahren wird vorgeschlagen, den evakuierten Zwischenraum zwischen dem Stickstoff- und Heliumtank mittels trockenem Stickstoffgases soweit abzukühlen, daß über Wärmeleitung der Heliumtank auf eine Temperatur von 77 K abgekühlt wird. Dieses Verfahren hat jedoch den Nachteil, daß der Stickstoff aus dem evakuierten Zwischenraum wieder entfernt werden muß. Da dies jedoch in der Regel nur unvollständig durchgeführt werden kann, frieren bei einer späteren Inbetriebnahme des Kryostaten die sich im evakuierten Zwischenraum befindenden Stickstoffreste am kälteren Heliumtank fest. Außerdem stellen mögliche Fehlbedienungen der Vakuumventile ein Sicherheitsrisiko dar, da durch entstehenden Überdruck aufgrund von verdampfendem einkondensierten Stickstoff bzw. Luft die Gefahr einer Explosion besteht. Zudem ist diese indirekte Kühlung über den zwischen dem Stickstofftank und dem Heliumtank liegenden evakuierten Zwischenraum ineffektiv, zeitaufwendig und führt im Fall eines einzigen Zwischenraums zwischen Stickstofftank und Heliumtank einerseits und der Umgebung andererseits außerdem zu einer Vereisung des Außenmantels des Kryostaten.

Eine weitere und die gängigste Methode ist daher in den Heliumtank zunächst flüssigen Stickstoff einzufüllen, wodurch der Tank auf eine Temperatur von 77 K abgekühlt wird. Durch diese Abkühlung wird dem Kryostaten der größte Teil der Gesamtwärme entzogen. Allerdings muß nach der Abkühlung der flüssige Stickstoff wieder vollständig aus dem Heliumtank entfernt werden. Verbleibende Stickstoffreste verschlechtern die Heliumstandzeiten, die in der Regel bei einem Jahr liegen und insbesondere Stickstoffreste auf der Magnetspule verschlechtern vor allem die Betriebssicherheit der Magnetspule, d.h. sie vergrößern das Risiko eines Quenchs, d.h. eines unbeabsichtigten Übergangs vom supraleitenden in den normalleitenden Zustand der Magnetspule. Weiterhin besteht bei optischen Kryostaten die Gefahr, daß sich optische Komponenten, wie Fenster, Spiegel oder dergleichen im Strahlengang mit festem Stickstoff überziehen. Weist der Stickstoff einen gewissen Sauerstoffanteil auf, ist er also mit Sauerstoff verunreinigt, so wird diese paramagnetische Komponente bei Inbetriebnahme der Magnetspule von dieser angezogen. Außerdem besteht durch die nötigen Umbauarbeiten beim Einfüllen bzw. Austauschen zweier verflüssigter Gase die erhöhte Gefahr, daß Atmosphärenluft bzw. Feuchtigkeit einkondensieren kann, was ebenfalls zu Fehlfunktionen führen und die Standzeit des Heliums verschlechtern kann. Weiterhin besteht eine erhöhte Sicherheitsgefahr aufgrund von Bedienungsfehlern.

Demgegenüber liegt der Erfindung die Aufgabe zugrunde, eine Vorrichtung der eingangs genannten Art mit einfachen Mitteln dahingehend zu modifizieren, daß einerseits größere Wärmemengen aus dem Kryostaten in relativ kurzer Zeit herausgeführt werden können, so daß die Vorkühlung des Heliumtanks in kurzer Zeit durchgeführt werden kann, wobei aber andererseits durch die Modifikation der Vorrichtung kein nennenswerter Wärmeeintrag in das zu beschleunigende Heliumgas erfolgen darf.

Diese Aufgabe wird erfindungsgemäß dadurch gelöst, daß der abgeschlossene Kreislauf einen Verdichter zum Fördern des Heliumgases aufweist, der als mehrstufiger Axialverdichter mit Lauf- und Leiträdern ausgebildet ist.

Durch die Anwendung eines solchen turbinenartigen Verdichters wird über den zwischen den einzelnen Verdichterstufen gleichgerichteten Gasstrom eine hohe Effizienz des Verdichters erreicht, so daß vergleichsweise geringe Antriebsleistungen für den Verdichter erforderlich sind, was zur Folge hat, daß auch die Wärmeabgabe vom Verdichter auf das Heliumgas gering ist.

Der Verdichter unterstützt den aufgrund der Temperaturunterschiede im Heliumgas bewirkten natürlichen Umlauf des Heliumgases, wodurch erreicht wird, daß größere Wärmemengen aus dem Kryostaten herausgeführt werden können, so daß die Vorkühlung des Heliumtanks in einer wesentlich kürzeren Zeit durchgeführt werden kann.

Bei der MR-Tomographie in der Medizin wird durch die erfindungsgemäße Vorrichtung die Betriebssicherheit erheblich gesteigert, da die Gefahr eines Quenches, der, wie eingangs bereits erwähnt, dann besonders häufig auftritt, wenn die Magnetspule, in der sich bei der Tomographie die zu untersuchende Person befindet, mit Stickstoff in Berührung gekommen ist, gemindert ist.

Bevorzugt ist der Wärmetauscherraum der Innenraum eines Plattenkondensators. Plattenkondensatoren haben den Vorteil, daß sie einerseits eine große Oberfläche aufweisen, andererseits mit einem unter Druck stehenden Gas beaufschlagt werden können.

Bevorzugt hängt der Wärmetauscher in einem offenen Behälter. In diesem offenen Behälter befindet sich außerdem der siedende Stickstoff, was den Vorteil hat, daß der in den gasförmigen Zustand übergegangene Stickstoff, d.h. das Stickstoffgas, problemlos aus dem Behälter entweichen kann.

Da bei dem Verdichter eine hohe Heliumdichtheit gefordert ist, diese Dichtheit aufgrund der extremen Temperaturunterschiede mittels Wellendichtungen nicht erreicht werden kann, ist vorteilhaft der Antrieb des Laufrads im Verdichtergehäuse angeordnet. Hierdurch wird vermieden, daß von einem außerhalb des Verdichters angeordneten Antrieb die Antriebsbewegung durch das Verdichtergehäuse hindurch auf das Laufrad übertragen und der Gehäusedurchtritt abgedichtet werden muß. Vorteilhaft ist das Laufrad um den in Strömungsrichtung axial angeordneten Antrieb angeordnet, und ist der Antrieb als Elektromotor ausgebildet.

Um den Antrieben möglichst wenig Wärme zu entziehen, weist das Leitrad einen dem Durchmesser des axial angeordneten Antriebs entsprechenden Kern auf. Hierdurch wird erreicht, daß der Gasstrom an der Außenseite der Antriebe vorbeiströmt, und somit mit den Antrieben selbst nicht in Berührung kommt. Die Antriebe erhalten sich dadurch auch eine geeignete Betriebstemperatur, da sie durch den elektrischen Widerstand und die Reibung in den Lagern ständig aufgewärmt werden. Für die Lagerung der Laufräder wird ein für tiefe Temperaturen geeignetes Spezialfett eingesetzt, so daß hierfür nur ein geringer Teil der Antriebsenergie benötigt wird.

Eine Umlenkung des in den Verdichter einströmenden Gasstromes in Richtung um die Antriebe herum wird vorteilhaft dadurch erreicht, daß der Einlaß des Verdichters sich kegelförmig erweiternd ausgebildet ist und einen innenliegenden, den Gasstrom in einem Kegelmantel aufteilende und um den Verdichterantrieb axial herumführenden Konus aufweist. Das einströmende Gas wird demnach bereits vor der ersten Verdichterstufe derart umgelenkt, daß es lediglich mit dem Laufrad in Berührung kommt und dabei den vom Laufrad umgebenen Antrieb umströmt.

Eine vorteilhafte Bündelung des den Verdichter verlassenden Gasstroms wird dadurch erreicht, daß der Auslaßstrom des Verdichters sich kegelförmig verjüngt und einen dem Einlaß entsprechenden Konus aufweist. Außerdem sind an der Innenseite des kegelförmigen Mantels des Auslasses in Längsrichtung sich erstreckende, als Leitelemente für den drallbehafteten Gasstrom dienende Führungselemente vorgesehen. Diese Führungselemente reduzieren den Drall des die letzte Verdichterstufe verlassenden Heliumgases.

Ein einfacher und kostengünstiger Aufbau des Verdichters wird dadurch erreicht, daß er mit seinen Lauf- und Leitstufen in Sandwichbauweise aufgebaut ist und die einzelnen Stufen über am Umfang angeordnete Zugstäbe miteinander verbunden sind. Diese Bauweise erlaubt einen den jeweils gegebenen Anforderungen entsprechenden Aufbau des Verdichters, so daß dieser auf die Menge des zu fördernden Gases und dessen Strömungsgeschwindigkeit exakt abgestellt werden kann.

Eine gute Heliumdichtigkeit wird dadurch erreicht, daß zwischen den einzelnen Lauf- oder Leitstufen Dichtungen, insbesondere Runddichtungen vorgesehen sind. Über diese Dichtungen wird sowohl der Austritt von Heliumgas in die Atmosphäre als auch die Verunreinigung des Heliumgases durch in den Verdichter eintretende Luft vermieden.

Die oben genannte Aufgabe wird bei einem Verfahren zum Vorkühlen des Heliumtanks eines Kryostaten auf etwa die Temperatur von siedendem Stickstoff, wobei in einem Wärmetauscherraum eines geschlossenen Kreislaufs Heliumgas auf die Temperatur von siedendem Stickstoff gebracht wird, danach dieses Heliumgas durch den Heliumtank des Kryostaten geleitet wird und anschließend in dem Wärmetauscherraum wieder auf die Temperatur von siedendem Stickstoff abgekühlt wird, erfindungsgemäß dadurch gelöst, daß das Helium mittels eines mehrstufigen Axialverdichters mit Lauf- und Leiträdern gefördert wird.

Bei dem erfindungsgemäßen Verfahren wird der Heliumtank des Kryostaten von einem Heliumgas durchströmt, das zuvor auf die Temperatur von siedendem Stickstoff, d.h. auf die Temperatur von 77 K gebracht worden ist. Im Heliumtank nimmt dieses Heliumgas Wärme auf und verläßt den Heliumtank in diesem aufgewärmten Zustand um anschließend wieder auf die Temperatur von siedendem Stickstoff abgekühlt zu werden, wobei es die im Heliumtank aufgenommene Wärme wieder abgibt. Über diesen Kreislauf, bei dem der Heliumtank mit Heliumgas mit einer Temperatur von 77 K durchströmt wird, wird diesem solange Wärmeenergie entzogen, bis er ebenfalls eine Temperatur von
77 K aufweist. Dieses Verfahren hat den wesentlichen Vorteil, daß das Innere des Heliumtanks ausschließlich mit Helium in Berührung kommt, und dadurch weder durch Stickstoff noch durch andere Gase verunreinigt wird. Da sich bei diesem Verfahren ausschließlich Helium im Heliumtank befindet, muß dieser nach dem Abkühlen auf die Temperatur von 77 K nicht gereinigt werden, sondern kann unmittelbar danach mit flüssigem Helium aufgefüllt werden. Um den Heliumtank und die sich im Heliumtank befindende Magnetspule nun von der Temperatur von 77 K auf die Temperatur von 4 K abzukühlen, bedarf es einer wesentlich geringeren Menge an flüssigem Helium, da bereits der weitaus größte Teil der Gesamtwärme dem Kryostaten durch die Abkühlung auf die Temperatur von 77 K entzogen worden ist. Aufgrund des abgeschlossenen Kreislaufs für das Heliumgas ist der Verbrauch an gasförmigem Helium ebenfalls auf ein Minimum reduziert. Dieses erfindungsgemäße Verfahren bietet demnach den Vorteil einer kostengünstigen und betreibssicheren Vorkühlung des Heliumtanks eines Kryostaten. Es vereinigt den Vorteil der Kühlung von Zimmertemperatur auf etwa 77 K durch Stickstoff mit dem, daß der Heliumtank und damit auch eine etwaige Magnetspule oder optische Komponenten nur mit Helium in Berührung kommen.

Gemäß einem bevorzugten Ausführungsbeispiel wird das Heliumgas in einem Wärmetauscher, insbesondere einem Plattenwärmetauscher abgekühlt. Über diesen Plattenwärmetauscher wird dem erwärmten, vom Kryostaten kommenden Heliumgas die im Heliumtank des Kryostaten aufgenommene Wärmeenergie wieder entzogen und dem Kühlmedium des Wärmetauschers zugeführt.

Das Heliumgas durchströmt den Wärmetauscher und der Wärmetauscher wird von siedendem Stickstoff umflossen. Hierbei entzieht der siedende Stickstoff seine Verdampfungsenthalpie dem Wärmetauscher, der seinerseits diese Wärmemenge dem durchströmenden Heliumgas entnimmt. Dadurch, daß die Heliumseite im Innern des Wärmetauschers und die Stickstoffseite außen vorgesehen ist, kann das im geschlossenen Kreislauf sich befindende Heliumgas unter Druck gehalten werden, und weist der an der Außenseite des Wärmetauschers sich befindende siedende Stickstoff Umgebungsdruck auf. Außerdem kann der in den gasförmigen Zustand übergegangene Stickstoff problemlos entweichen. Die vom flüssigen in den gasförmigen Aggregatzustand notwendige Energie entzieht der Stickstoff dem Heliumgas, wodurch dessen Kühlung bewirkt wird.

Um den Wärmeübergang vom gasförmigen Helium zum flüssigen Stickstoff im Wärmetauscher aufrechtzuerhalten, wird dem Wärmetauscher eine dem verdampfenden Stickstoff entsprechende Menge flüssigen Stickstoffs ständig zugeführt. Dadurch wird erreicht, daß der Flüssigkeitsspiegel des flüssigen Stickstoffs konstant gehalten wird.

Vorteilhaft wird der Druck des Heliumgases mittels eines Reservoirs aufrecht erhalten. Dadurch daß das Heliumgas unter leichtem Druck steht, wird erreicht, daß das Heliumgas im Kreislauf nicht durch Leckage bedingt mit der Außenluft verunreinigt werden kann. Außerdem wird der Druck im Heliumtank während des Abkühlvorganges und der damit verbundenen Kontraktion des Heliumgases konstant gehalten.

Weitere Vorteile der Erfindung ergeben sich aus der nachfolgenden Beschreibung, in der unter Bezugnahme auf die Zeichnung, ein bevorzugtes Ausführungsbeispiel im einzelnen beschrieben ist. In der Zeichnung zeigen:
- Fig.1: eine Prinzipskizze des Kreislaufs; und
- Fig.2: eine Seitenansicht des das Heliumgas fördernden Verdichters, wobei die obere Hälfte des Verdichters aufgeschnitten ist.

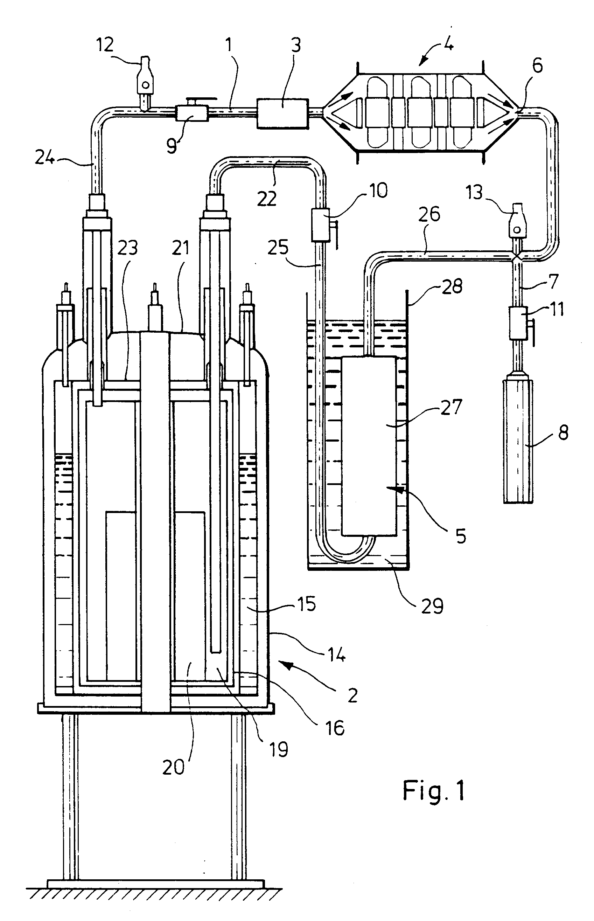

Bei der in der Fig.1 gezeigten Prinzipskizze sind über eine Rohrleitung 1, die wärmeisoliert ist, ein mit 2 bezeichneter Kryostat, ein erster Wärmetauscher 3, ein als Umwälzpumpe für das sich in der Rohrleitung befindende Heliumgas dienender Verdichter 4 und ein zweiter Wärmetauscher 5 miteinander verbunden. Nach dem Ausgang 6 des Verdichters 4 ist die Rohrleitung 1 über eine Verbindungsleitung 7 mit einem Helium enthaltenden Reservoir 8 verbunden. Außerdem weisen die Rohrleitung 1 und die Verbindungsleitung 7 Absperrventile 9, 10 und 11 auf, mit denen der Gasstrom in den Leitungen unterbrochen werden kann. Das Absperrventil 11 dient außerdem zur Reduktion des Druckes des sich im Reservoir 8 befindenden Heliums. Schließlich ist die Rohrleitung 1 mit Sicherheitsventilen 12 und 13 versehen über die ein zu großer Überdruck im geschlossenen Kreislauf abgebaut werden kann. Dieser Überdruck entsteht beim Aufwärmen des Systems und dem damit verbundenen Expandieren des kalten Heliumgases.

Der Kryostat 2 weist innerhalb eines äußeren Mantels 14 von außen nach innen gesehen einen Stickstofftank 15, einen Strahlungsschild 16, einen Heliumtank 19 und einen sich im Heliumtank 19 befindenden Spulenkörper 20 auf. An der Oberseite 21 ist der Kryostat 2 mit einem Leitungsabschnitt 22 versehen, der den äußeren Mantel 14, ein Stickstoffstrahlungsschild 23 und den Strahlungsschild 16 in Stutzen durchgreift und im Heliumtank 19 mündet. Ein zweiter Leitungsabschnitt 24 ist ebenfalls mit dem Heliumtank 19 verbunden und durchgreift die Strahlungsschilder 16 und 23, bevor er durch den äußeren Mantel 14 nach außen geführt ist. Im Anschluß an diese Leitungsabschnitte 22 und 24 befinden sich die Absperrventile 10 und 9, über die der lnnenraum des Heliumtanks 19 mit der Rohrleitung 1 verbindbar ist.

Der Wärmetauscher 5, der bevorzugt über flexible Schläuche 25 und 26 mit der Rohrleitung 1 verbunden ist, weist mehrere zueinander parallele Hohlplatten 27 auf, die die Kühlfläche für das durchströmende Heliumgas bilden. Dieser Wärmetauscher 5 hängt in einem Behälter 28, in dem sich flüssiger Stickstoff 29 befindet. Dieser flüssige Stickstoff 29 umfließt den Wärmetauscher 5 vollständig und hält diesen auf der Siedetemperatur des Stickstoffes von 77 K.

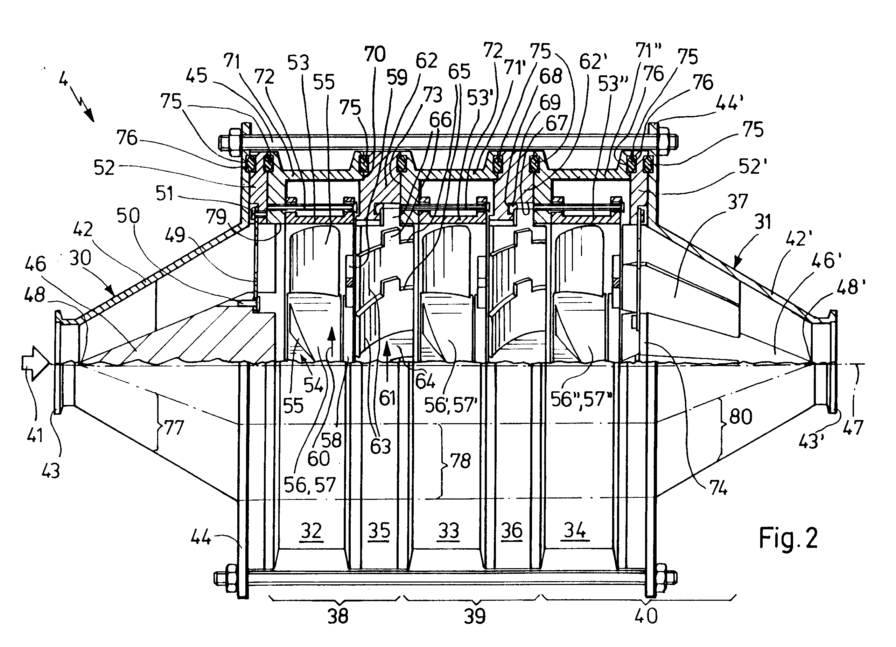

In Strömungsrichtung gesehen ist vor dem Verdichter 4 in der Rohrleitung 1 der Wärmetauscher 3 angeordnet. Dieser Wärmetauscher 3 dient als Heizung für das sich in der Rohrleitung 1 befindende Heliumgas, wodurch eine zu starke Abkühiung des Verdichters 4 vehindert werden kann. Der Wärmetauscher 3 ist demnach ein Schutz für den Verdichter 4. Zur detaillierten Beschreibung des Verdichters 4 wird auf die Fig.2 verwiesen, in der eine vergrößerte Darstellung des Verdichters 4 wiedergegeben ist. Der Verdichter 4 weist zwischen seinem Ansaugstutzen 30 und seinem Auslaßstutzen 31 drei Laufstufen 32, 33 und 34 auf, zwischen denen zwei Leitstufen 35 und 36 vorgesehen ßind. Die Laufstufe 32 bildet mit der Leitstufe 35 eine erste Verdichterstufe 38 und die Laufstufe 34 bildet mit der Leitstufe 36 eine zweite Verdichterstufe 39. Schließlich ist im Auslaßstutzen 31 eine Leitvorrichtung 37 vorgesehen, die mit der Laufstufe 34 eine dritte Verdichterstufe 40 bildet. Der Ansaugstutzen 30, in den das Heliumgas in Richtung des Pfeils 41 einströmt besitzt einen sich kegelförmig aufweitenden Mantel 42, der mit zwei Flanschen 43 und 44 versehen ist. Der Flansch 43 dient zum Anschluß der Rohrleitung 1, und über den Flansch 44 wird der Verdichter 4, wie weiter unten noch näher beschrieben wird, mittels Zugbolzen 45 zusammengehalten. Im Innern des Mantels 42 befindet. sich ein kegelförmiger Konus 46, dessen Achse konzentrisch zur Längsachse 47 des Verdichters 4 liegt, und dessen Spitze 48 in Richtung des Flansches 43 zeigt. Dieser Konus 46 ist über ein Halteelement 49 und Schrauben 50 und 51 mit einem Gehäusering 52 verbunden, dessen Seelenachse in der Längsachse 47 des Verdichters 4 liegt.

An diesen Ansaugstutzen 30 schließt sich die Laufstufe 32 der ersten Verdichterstufe 38 an. Diese Laufstufe 32 weist ein Laufstufengehäuse 53 auf das im wesentlichen ringförmig ausgebildet ist und dessen Seelenachse ebenfalls in der Längsachse 47 des Verdichters liegt. In diesem Laufstufengehäuse 53 ist das Laufrad 54 angeordnet, dessen Laufschaufeln 55 sich von der Nabe 56 bis zur Innenfläche deß Laufstufengehäuses 53 erstrecken. In die Nabe 56 des Laufrades 54 ist der Rotor eines als Antrieb 57 für das Laufrad dienenden Elektromotors integriert, dessen Stator 58 über ein Befestigungselement 59 mit dem Laufstufengehäuse 53 fest verbunden ist. Der Rotor dreht sich bei dem in der Fig. 2 wiedergegebenen Ausführungsbeispiel in Richtung des Pfeiles 60. An die Laufstufe 32 schließt sich in Strömungsrichtung die Leitstufe 35 an, die aus einem Leitrad 61 und einem dieses umgebenden Gehäuse 62 besteht. Das Leitrad 61 Weist Leitschaufeln 63 auf, die sich von der Nabe 64 bis zur Innenfläche des Gehäuses 62 erstrecken. Eine einfache Festlegung der Leitschaufeln 63 im Gehäuse 62 wird dadurch erreicht, daß die Spitzen 65 der Leitschaufeln 63 Nasen 66 aufweisen, die in eine Ausnehmung 67 des Gehäuses 62 greifen, in dem in einer Ringnut 68 eine Quetschdichtung 69 vorgesehen ist, die durch die in die Ausnehmung 67 eingeführten Nasen 66 der Leitschaufeln 63 verformt wird und auf diese Weise die Nasen 66 festhält. Bevorzugt entspricht der Durchmesser der Nabe 64 des Leitrades 61 dem Durchmesser der Nabe 56 des Laufrads 54. Die Krümmung der Laufschaufeln 63 ist so gewählt, daß das mit einem Drall behaftete in das Leitrad 61 eintretende Heliumgas koaxial zur Längsachse 47 umgelenkt wird, so daß das Gas mit zur Längsachse 47 koaxialer Strömungsrichtung in die zweite Laufstufe 33 einströmt.

Der äußere, der Laufstufe 32 zugewandte Umfangsrand 70 des Gehäuses 62 liegt an einem im Querschnitt im wesentlichen L-förmigen Verbindungsring 71 an, der seinerseits über eine Schraube 72 mit dem Laufstufengehäuse 53 verbunden ist. Dabei fluchtet die Innenfläche des Laufstufengehäuses 53 mit der Innenfläche 79 des Verbindungsrings 71. An dem der Laufstufe 33 zugewandten Umfangsrand 73 schließt sich ein zweiter Verbindungsring 71′ an, der mit dem Laufstufengehäuse 53′ der zweiten Laufstufe 33 über eine Schraube 72′ verbunden ist. Der Aufbau der zweiten und der dritten Laufstufe 33 und 34 sowie der zweiten Leitstufe 36 entsprechen dem Aufbau der ersten Laufstufe 32 bzw. der ersten Leitstufe 35.

Schließlich besteht der Auslaßstutzen 31 aus einem dem Mantel 42 entsprechenden kegelförmigen Mantel 42′, in dem ebenfalls ein Konus 46′ derart angeordnet ist, daß dessen Spitze 48′ in Richtung des Flansches 43′ des Auslaßstutzens 31′ zeigt. Das der Spitze 48′ gegenüberliegende Ende 74 ist über die Leitvorrichtung 37 mit einem Gehäusering 52′ verbunden, so daß die Achse des Konus 46′ auf der Längsachse 47 des Verdichters 4 liegt.

Die beiden Flansche 44 und 44′ des Ansaug- und Auslaßstutzens 30 und 31 sind über mehrere am Umfang des Verdichters 4 angeordnete Zugbolzen 45 miteinander verbunden. Über diese Zugbolzen 45 werden die aneinander anliegenden Gehäuseteile des Verdichters 4, wie Gehäusering 52, Verbindungsring 71, Gehäuse 62 der ersten Leitstufe 35, Verbindungsring 71′, Gehäuse 62′ der Zweiten Leitstufe 36, Verbindungsring 71˝ und Gehäusering 52′ aneinander gepreßt. Zur Abdichtung sind Runddichtungen 75 vorgesehen, die jeweils zwischen den vorgenannten Gehäuseteilen in dafür vorgesehenen Ringnuten 76 angeordnet sind. Durch das Anziehen des Zugbolzens 45 werden diese Runddichtungen 75 in die Ringnut 76 gequetscht, wodurch das Innere des Verdichters 4 sicher gegen die den Verdichter 4 umgebende Atmosphäre abgedichtet wird.

Über den Konus 46 wird das in Richtung des Pfeils 41 durch die Öffnung des Flansches 43 in den Verdichter 4 eintretende Heliumgs aufgeteilt, so daß das Gas den Konus 46 kegelmantelförmig mit dem Strömungsquerschnitt 77 umströmt. Die Lauf- und Leitstufen 32 bis 36 werden mit dem Strömungsquerschnitt 78 durchströmt, Wobei der Strömungsquerschnitt 78 durch die Naben 56, 56′, 56˝, 64 und 64′ und die Innenoberflächen der Laufstufengehäuse 53, 53′ und 53˝ und den Gehäusen 62 und 62′ begrenzt wird. Hieraus ergibt sich der Vorteil, daß die drei in den Naben 56, 56′ und 56˝ liegenden Antriebe 57, 57′ und 57˝ vom kalten Heliumgas nicht angeströmt sondern umströmt werden, so daß diese nicht übermäßig abgekühlt werden. Am Ausgang der Laufstufe 34 wird das noch mit einem Drall behaftete Heliumgas über die Leitvorrichtung 37 parallel zur Mantellinie des Mantels 42′ umgelenkt und über den Konus 46′ mit dem Strömungsquerschnitt 80 in einen gebündelten Gasstrom überführt, der den Verdichter 4 über die Öffnung des Flansches 43′ verläßt.

Der in Fig. 2 wiedergegebene Verdichter 4 weist 3 Verdichterstufen 38, 39 und 40 auf. Eine einfache und kostengünstige Anpassung an unterschiedliche Strömungsgeschwindigkeiten undmassen wird vorteilhaft dadurch erreicht, daß zu den 3 Verdichterstufen noch weitere in Reihe hinzugeschaltet oder von den 3 vorhandenen eine oder zwei herausgenommen werden. Für die Anpassung bedarf es lediglich unterschiedlich langer Zugbolzen 45.

## Patentansprüche

1. Vorrichtung zum Vorkühlen des Heliumtanks (19) eines Kryostaten (2) auf etwa die Temperatur von siedendem Stickstoff, insbesondere eines optischen Kryostaten mit optischen Komponenten im Heliumtank, oder eines NMR-Kryostaten bzw. eines medizinischen NMR-Kryostaten für Kernspintomographie für die Aufnahme einer supraleitenden Magnetspule, mit einem abgeschlossenen, Heliumgas beinhaltenden Kreislauf, über den wenigstens der zu kühlende Heliumtank (19) des Kryostaten (2) und ein Wärmetauscherraum eines von siedendem Stickstoff (29) umgebenen Wärmetauschers (5) miteinander verbunden sind, dadurch gekennzeichnet, daß der Kreislauf einen Verdichter (4) zum Fördern des Heliumgases aufweist, der als mehrstufiger Axialverdichter mit Lauf- und Leiträdern (54 und 61) ausgebildet ist.

2. Vorrichtung nach Anspruch 1, dadurch gekennzeichnet, daß der Wärmetauscherraum der Innenraum eines Plattenwärmetauschers (5) ist.

3. Vorrichtung nach Anspruch 1, dadurch gekennzeichnet, daß der Wärmetauscher (5) in einem offenen Behälter (28) hängt.

4. Vorrichtung nach Anspruch 1, dadurch gekennzeichnet, daß der Kreislauf ein Helium-Reservoir (8) aufweist.

5. Vorrichtung nach Anspruch 1, dadurch gekennzeichnet daß der Antrieb (57) des Laufrades (54) im Gehäuse des Verdichters (4) angeordnet ist.

6. Vorrichtung nach Anspruch 5, dadurch gekennzeichnet, daß das Laufrad (54) um den in Strömungsrichtung axial angeordneten Antrieb (57) vorgesehen ist.

7. Vorrichtung nach Anspruch 5, dadurch gekennzeichnet, daß der Antrieb (57) als Elektromotor ausgebildet ist.

8. Vorrichtung nach Anspruch 6, dadurch gekennzeichnet, daß das Leitrad (61) einen dem Durchmesser des axial angeordneten Antriebs (57) entsprechenden Kern (Nabe 64) aufweist.

9. Vorrichtung nach einem der Ansprüche 5 bis 8, dadurch gekennzeichnet, daß der Ansaugstutzen (30) des Verdichters (4) sich kegelförmig erweiternd ausgebildet ist und einen innenliegenden, den Gasstrom in einen Kegelmantel aufspaltenden und um den Verdichterantrieb (57) axial herumführenden Konus (46) aufweist.

10. Vorrichtung nach Anspruch 9, dadurch gekennzeichnet, daß der Auslaßstutzen (31) des Verdichters (4) sich kegelförmig verjüngt, einen dem Einlaßstutzen (30) entsprechenden Konus (46') aufweist und an der Innenseite des kegelförmigen Mantels (42') in Längsrichtung sich erstreckende Führungslamellen (Leitvorrichtung 37) vorgesehen sind.

11. Vorrichtung nach Anspruch 1, dadurch gekennzeichnet, daß der Verdichter (4) mit seinen Lauf- und Leitstufen (32 bis 36) in Sandwich-Bauweise aufgebaut ist, und die einzelnen Stufen (32 bis 36) über am Außenumfang des Verdichters (4) angeordnete Zugbolzen (45) miteinander verbunden sind.

12. Vorrichtung nach Anspruch 11, dadurch gekennzeichnet, daß zwischen den einzelnen Lauf- und/oder Leitstufen (32 bis 36) Dichtungen (75), insbesondere Runddichtungen vorgesehen sind.

13. Vorrichtung nach Anspruch 10, dadurch gekennzeichnet, daß der Wärmetauscherraum der Innenraum eines Plattenwärmetauschers (5) ist,
daß der Wärmetauscher (5) von siedendem Stickstoff (29) umgeben ist,
daß der Wärmetauscher (5) in einem offenen Behälter (28) hängt,
daß der Kreislauf ein Helium-Reservoir (8) aufweist,
daß der Antrieb (57) des Laufrades (54) im Gehäuse des Verdichters (4) angeordnet ist,
daß das Laufrad (54) um den in Strömungsrichtung axial angeordneten Antrieb (57) vorgesehen ist,
daß der Antrieb (57) als Elektromotor ausgebildet ist, daß das Leitrad (61) einen dem Durchmesser des axial angeordneten Antriebs (57) entsprechenden Kern (Nabe 64) aufweist,
daß der Verdichter (4) mit seinen Lauf- und Leitstufen (32 bis 36) in Sandwich-Bauweise aufgebaut ist, und die einzelnen Stufen (32 bis 36) über am Außenumfang des Verdichters (4) angeordnete Zugbolzen (45) miteinander verbunden sind,
daß zwischen den einzelnen Lauf- und/oder Leitstufen (32 bis 36) Dichtungen (75), insbesondere Runddichtungen vorgesehen sind.

14. Verfahren zum Vorkühlen des Heliumtanks (19) eines Kryostaten (2) auf etwa die Temperatur von siedendem Stickstoff, wobei in einem Wärmetauscherraum eines geschlossenen Kreislaufs Heliumgas auf die Temperatur von siedendem Stickstoff gebracht wird, danach dieses Heliumgas durch den Heliumtank (19) des Kryostaten geleitet wird und anschließend in dem Wärmetauscherraum wieder auf die Temperatur von siedendem Stickstoff abgekühlt wird, dadurch gekennzeichnet, daß das Heliumgas mittels eines mehrstufigen Axialverdichters (4) mit Lauf- und Leiträdern (54 und 61) gefördert wird.

15. Verfahren nach Anspruch 14, dadurch gekennzeichnet, daß das Heliumgas in einem Wärmetauscher (5), insbesondere einem Plattenwärmetauscher, abgekühlt wird.

16. Verfahren nach Anspruch 15, dadurch gekennzeichnet, daß das Heliumgas den Wärmetauscher (5) durchströmt und der Wärmetauscher von siedendem Stickstoff umschlossen wird.

17. Verfahren nach Anspruch 16, dadurch gekennzeichnet, daß die Verdampfungsenthalpie des Stickstoffs zur Kühlung des Heliumgases genutzt wird.

18. Verfahren nach Anspruch 17, dadurch gekennzeichnet, daß dem Wärmetauscher eine dem verdampfenden Stickstoff entsprechende Menge flüssigen Stickstoffes ständig zugeführt wird.

19. Verfahren nach Anspruch 14, dadurch gekennzeichnet, daß der Druck des Heliumgases mittels eines Reservoirs (8) aufrecht erhalten wird.

## Claims

1. A device for precooling the helium tank (19) of a cryostat (2), in particular an optical cryostat comprising optical components in the helium tank, an NMR cryostat, or a medical NMR cryostat for nuclear spin tomography, respectively, for accommodating a superconductive magnet coil to approximately the temperature of boiling nitrogen, with a closed helium gas circuit interconnecting at least the helium tank (19), to be cooled, of the cryostat (2) and a heat exchanger chamber of a heat exchanger (5) surrounded by boiling nitrogen (29), characterized in that the circuit comprises a compressor (4), for supplying the helium gas, which is constructed as multi-stage axial flow compressor with impeller and guide wheels (54 and 61).

2. A device according to claim 1, characterized in that the heat exchanger chamber is the inner space of a plate heat exchanger (5).

3. A device according to claim 1, characterized in that the heat exchanger (5) is suspended in an open tank (28).

4. A device according to claim 1, characterized in that the circuit comprises a helium reservoir (8).

5. A device according to claim 1, characterized in that the drive (57) of the impeller wheel (54) is arranged in the housing of the compressor (4).

6. A device according to claim 5, characterized in that the impeller wheel (54) is provided around the drive (57) which is arranged axially relative to the direction of flow.

7. A device according to claim 5, characterized in that the drive (57) is constructed as an electric motor.

8. A device according to claim 6, characterized in that the guide wheel (61) has a core (hub 64) corresponding to the diameter of the axially arranged drive (57).

9. A device according to any one of claims 5 to 8, characterized in that the inlet pipe (30) of the compressor (4) has a conically widening shape and comprises an inner cone (46) splitting up the gas flow into a conical shell and guiding it axially around the compressor drive (57).

10. A device according to claim 9, characterized in that the outlet pipe (31) of the compressor (4) tapers conically, comprises a cone (46') corresponding to that of the inlet pipe (30) and guide ribs (guide means 37) extending in the longitudinal direction are provided on the inside of the conical jacket (42').

11. A device according to claim 1, characterized in that a sandwich construction is selected for the impeller and guide stages (32 to 36) of the compressor (4) and the individual stages (32 to 36) are interconnected by tension bars (45) arranged about the circumference of the compressor (4).

12. A device according to claim 11, characterized in that seals (75), in particular circular seals, are provided between the individual impeller and/or guide stages (32 to 36).

13. A device according to claim 10, characterized in that the heat exchanger chamber is the inner space of a plate heat exchanger (5),
that the heat exchanger (5) is surrounded by boiling nitrogen (29),
that the heat exchanger (5) is suspended in an open tank (28),
that the circuit comprises a helium reservoir (8),
that the drive (57) of the impeller wheel (54) is arranged in the housing of the compressor (4),
that the impeller wheel (54) is provided around the drive (57) which is arranged axially relative to the direction of flow,
that the drive (57) is formed as an electric motor,
that the guide wheel (61) has a core (hub 64) corresponding to the diameter of the axially arranged drive (57),
that a sandwich construction is selected for the impeller and guide stages (32 to 36) of the compressor (4) and the individual stages (32 to 36) are interconnected by tension bars (45) arranged about the circumference of the compressor (4),
that seals (75), in particular circular seals, are provided between the individual impeller and/or guide stages (32 to 36).

14. Method of precooling the helium tank (19) of a cryostat (2) to approximately the temperature of boiling nitrogen, wherein in a heat exchanger chamber of a closed circuit, helium gas it brought to the temperature of boiling nitrogen and subsequently the helium gas is guided through the helium tank (19) of the cryostat and thereafter cooled down again in the heat exchanger chamber to the temperature of boiling nitrogen, characterized in that the helium gas is supplied by means of a multi-stage axial flow compressor (4) with impeller and guide wheels (54 and 61).

15. A method according to claim 14, characterized in that the helium gas is cooled down in a heat exchanger (5), in particular in a plate heat exchanger.

16. A method according to claim 15, characterized in that the helium gas flows through the heat exchanger (5) and the heat exchanger is surrounded by boiling nitrogen.

17. A method according to claim 16, characterized in that the enthalpy of vaporization of the nitrogen is utilized for cooling the helium gas.

18. A method according to claim 17, characterized in that the heat exchanger is constantly supplied with a quantity of liquid nitrogen corresponding to the vaporizing nitrogen.

19. A method according to claim 14, characterized in that the pressure of the helium gas is maintained by means of a reservoir (8).

## Revendications

1. Dispositif pour préréfrigérer la cuve d'hélium (19) d'un cryostat (2) à environ la température d'azote en ébullition, notamment d'un cryostat optique avec des composants optiques dans le réservoir d'hélium, ou d'un cryostat de RMN (Résonance Magnétique Nucléaire) ou encore d'un cryostat de RMN à usage médical pour la tomographie à spin nucléaire, destiné à recevoir une bobine magnétique supraconductrice, avec un circuit fermé contenant de l'hélium à l'état gazeux et par lequel sont mutuellement reliés au moins la cuve d'hélium (19) à refroidir du cryostat (2) et une chambre d'échange de chaleur d'un échangeur de chaleur (5) entouré d'azote en ébullition (29), **caractérisé** en ce que le circuit comporte, pour faire circuler l'hélium à l'état gazeux, un compresseur (4) qui est réalisé sous forme de compresseur axial à plusieurs étages avec des roues mobiles et des roues fixes (54 et 61).

2. Dispositif selon la revendication 1, **caractérisé** en ce que la chambre d'échange de chaleur est la chambre intérieure d'un échangeur de chaleur (5) à plaques.

3. Dispositif selon la revendication 1, **caractérisé** en ce que l'échangeur de chaleur (5) est suspendu dans un récipient ouvert (28).

4. Dispositif selon la revendication 1, **caractérisé** en ce que le circuit comporte un réservoir d'hélium (8).

5. Dispositif selon la revendication 1, **caractérisé** en ce que l'entraînement (57) de la roue mobile (54) est disposé dans le carter du compresseur (4).

6. Dispositif selon la revendication 5, **caractérisé** en ce que la roue mobile (54) est prévue autour de l'entraînement (57), disposé axialement dans la direction d'écoulement.

7. Dispositif selon la revendication 5, **caractérisé** en ce que l'entraînement (57) est réalisé sous forme de moteur électrique.

8. Dispositif selon la revendication 6, **caractérisé** en ce que la roue fixe (61) présente une partie centrale (moyeu 64) correspondant au diamètre de l'entraînement (57) disposé axialement.

9. Dispositif selon l'une quelconque des revendications 5 à 8, **caractérisé** en ce que la tubulure d'aspiration (30) du compresseur (4) est configurée en s'élargissant coniquement et présente un cône intérieur (46), divisant le flux de gaz en une aire latérale de cône et le dirigeant axialement autour de l'entraînement (57) du compresseur.

10. Dispositif selon la revendication 9, **caractérisé** en ce que la tubulure d'évacuation (31) du compresseur (4) se rétrécit coniquement et présente un cône (46') correspondant à la tubulure d'aspiration (30), des lamelles de guidage (dispositif directeur 37) étant prévues, qui s'étendent en direction longitudinale sur le côté intérieur de l'enveloppe conique (42').

11. Dispositif selon la revendication 1, **caractérisé** en ce que le compresseur (4) est réalisé avec ses étages mobiles et fixes (32 à 36) en construction sandwich, les étages individuels (32 à 36) étant mutuellement assemblés par des tirants (45) disposés sur la périphérie extérieure du compresseur (4).

12. Dispositif selon la revendication 11, **caractérisé** en ce que des joints d'étanchéité (75), notamment des joints d'étanchéité annulaires, sont prévus entre les étages mobiles et/ou fixes individuels (32 à 36).

13. Dispositif selon la revendication 10, **caractérisé** en ce que la chambre d'échange de chaleur est la chambre intérieure d'un échangeur de chaleur (5) à plaques,
en ce que l'échangeur de chaleur (5) est entouré d'azote en ébullition (29),
en ce que l'échangeur de chaleur (5) est suspendu dans un récipient ouvert (28),
en ce que le circuit comporte un réservoir d'hélium (8),
en ce que l'entraînement (57) de la roue mobile (54) est disposé dans le carter du compresseur (4),
en ce que la roue mobile (54) est prévue autour de l'entraînement (57), disposé axialement dans la direction d'écoulement,
en ce que l'entraînement (57) est réalisé sous forme de moteur électrique,
en ce que la roue fixe (61) présente une partie centrale (moyeu 64) correspondant au diamètre de l'entraînement (57) disposé axialement,
en ce que le compresseur (4) est réalisé avec ses étages mobiles et fixes (32 à 36) en construction sandwich, les étages individuels (32 à 36) étant mutuellement assemblés par des tirants (45) disposés sur la périphérie extérieure du compresseur (4),
en ce que des joints d'étanchéité (75), notamment des joints d'étanchéité annulaires, sont prévus entre les étages mobiles et/ou fixes individuels (32 à 36).

14. Procédé pour préréfrigérer la cuve d'hélium (19) d'un cryostat (2) à environ la température d'azote en ébullition, de l'hélium à l'état gazeux étant amené à la température d'azote en ébullition dans une chambre d'échange de chaleur d'un circuit fermé, cet hélium à l'état gazeux étant ensuite dirigé dans la cuve d'hélium (19) du cryostat puis, dans la chambre d'échange de chaleur, à nouveau refroidi à la température d'azote en ébullition, **caractérisé** en ce qu'on fait circuler l'hélium à l'état gazeux au moyen d'un compresseur axial (4) à plusieurs étages, avec des roues mobiles et des roues fixes (54 et 61).

15. Procédé selon la revendication 14, **caractérisé** en ce que l'hélium à l'état gazeux est refroidi dans un échangeur de chaleur (5), notamment dans un échangeur de chaleur à plaques.

16. Procédé selon la revendication 15, **caractérisé** en ce que l'hélium à l'état gazeux circule à travers l'échangeur de chaleur (5), et l'échangeur de chaleur est entouré d'azote en ébullition.

17. Procédé selon la revendication 16, **caractérisé** en ce qu'on utilise l'enthalpie d'évaporation de l'azote pour refroidir l'hélium à l'état gazeux.

18. Procédé selon la revendication 17, **caractérisé** en ce que l'échangeur de chaleur est alimenté en permanence d'une quantité d'azote liquide correspondant à l'azote évaporé.

19. Procédé selon la revendication 14, **caractérisé** en ce qu'on maintient la pression de l'hélium à l'état gazeux au moyen d'un réservoir (8).
